# EUROPÄISCHE PATENTSCHRIFT

(11) **EP 3 443 663 B1**
(45) Veröffentlichungstag und Bekanntmachung des Hinweises auf die Patenterteilung: **24.03.2021**
(21) Anmeldenummer: 17716908.3
(22) Anmeldetag: 12.04.2017
(51) Int. Cl.: H03F 3/189, H03C 1/00, H03F 3/217, H03F 3/38

(54) **MODULATOR FÜR EINEN DIGITALEN VERSTÄRKER**
MODULATOR FOR A DIGITAL AMPLIFIER
MODULATEUR POUR AMPLIFICATEUR NUMÉRIQUE

(30) Priorität: 13.04.2016 DE 102016106790
(43) Veröffentlichungstag der Anmeldung: 20.02.2019
(73) Patentinhaber: Forschungsverbund Berlin E.V., 12489 Berlin (DE)
(72) Erfinder: HÜHN, Florian, 10247 Berlin (DE)
(74) Vertreter: Gulde & Partner
(86) Internationale Anmeldenummer: PCT/EP2017/058790
(87) Internationale Veröffentlichungsnummer: WO 2017/178534

(56) Entgegenhaltungen:
- EP-A1- 2 750 288
- EP-A1- 2 750 288
- WO-A1-02/073821
- WO-A1-02/073821
- US-A1- 2011 267 127
- US-A1- 2015 280 732
- STAUTH J T ET AL: "Pulse-density modulation for RF applications: The radio-frequency power amplifier (RF PA) as a power converter", POWER ELECTRONICS SPECIALISTS CONFERENCE, 2008. PESC 2008. IEEE, IEEE, PISCATAWAY, NJ, USA, 15. Juni 2008 (2008-06-15), Seiten 3563-3568, XP031300510, ISBN: 978-1-4244-1667-7
- STAUTH J T ET AL: "Pulse-density modulation for RF applications: The radio-frequency power amplifier (RF PA) as a power converter", POWER ELECTRONICS SPECIALISTS CONFERENCE, 2008. PESC 2008. IEEE, IEEE, PISCATAWAY, NJ, USA, 15 June 2008 (2008-06-15), pages 3563-3568, XP031300510, ISBN: 978-1-4244-1667-7

## Beschreibung

Die vorliegende Erfindung betrifft einen Modulator für einen digitalen Verstärker und eine Vorrichtung mit einem solchen Modulator und einem digitalen Verstärker.

### Stand der Technik

Digitale Leistungsverstärker, auch kurz digitale Verstärker genannt, und Leistungssteller haben sich in den vergangenen Jahren im niederfrequenten Bereich aufgrund ihrer vielen Vorteile rasant durchgesetzt. Insbesondere der konstant hohe Wirkungsgrad über nahezu den gesamten Ausgangsleistungsbereich ermöglicht einen äußerst energieeffizienten und damit auch umweltschonenden Betrieb.

Im Bereich der Mikrowellentechnik konnten sich digitale Verstärker hingegen bisher noch nicht durchsetzen. Das gleichzeitige Erreichen einer hohen Ausgangsleistung mit guter Energieeffizienz sowie hoher Bandbreite und Linearität stellen angesichts der geringen Reserven zu den Frequenzgrenzen der Transistoren noch immer große Herausforderungen dar.

Digitale Verstärker erzeugen ein wertdiskretes Ausgangssignal, in der einfachsten Bauweise ein binäres Signal, in die das gewünschte analoge Ausgangssignal so kodiert ist, dass Zwischenwerte des Ausgangssignals durch einfache Bandpassfilterung am Ausgang des Verstärkers wiederhergestellt werden können. Die Anordnung, die das zu verstärkende Signal in ein Eingangssignal des digitalen Verstärkers entsprechend kodiert, wird Modulator genannt. Für Hochfrequenzsignale (HF-Signale) verhindern physikalische und technische Rahmenbedingungen die Übernahme der aus dem niederfrequenten Bereich bekannten Modulationsarten.

Aufgabe des Modulators ist es, aus dem Eingangssignal einen solchen Bitstrom zu erzeugen, der vom Verstärker mit wünschenswerterweise möglichst hohem Wirkungsgrad verstärkt werden kann und der nach Passieren des Bandfilters am Ausgang einer verstärkten und auf die Trägerfrequenz hochgemischten Version des Eingangssignals des Modulators entspricht.

In modernen Kommunikationssystemen umfasst das Eingangssignal typischerweise sowohl Variationen in seiner Phasenlage als auch in seiner Amplitude, die die zu übertragenden Informationen kodieren. Es liegt entweder als analoges Signal vor oder als digitale Repräsentation eines analogen Signals mit für die jeweilige Aufgabe hinreichend hoher Amplituden- und Zeitauflösung.

Aus dem Stand der Technik sind zwei Modulationsverfahren für digitale Verstärker bekannt. S. Hori beschreibt in "A 0.7-3GHz envelope ΔΣ modulator using phase modulated carrier clock for multi-mode/band switching amplifiers", Radio Frequency Integrated Circuits Symposium (RFIC) 2011, 5.-7. Juni 2011, S. 1-4, Envelope Delta Sigma Modulation (EDSM). EDSM erzeugt keinen oder genau einen Puls pro Schwingung des phasenmodulierten Trägersignals. Feinere Abstimmung der resultierenden Ausgangsamplitude durch Pulsbreite ist nicht möglich.

Ein anderes Verfahren ist Band Pass Delta Sigma Modulation (BPDSM), beispielsweise beschrieben in US 2015/0280732 A1. Die BPDSM erfordert eine Überabtastung des HF-Signals, was in einer erhöhten Anzahl an Schaltvorgängen pro Trägerfrequenzperiode resultiert und so zu Umladungsverlusten im Verstärker führt.

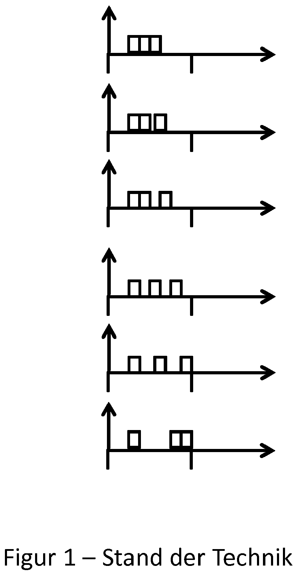

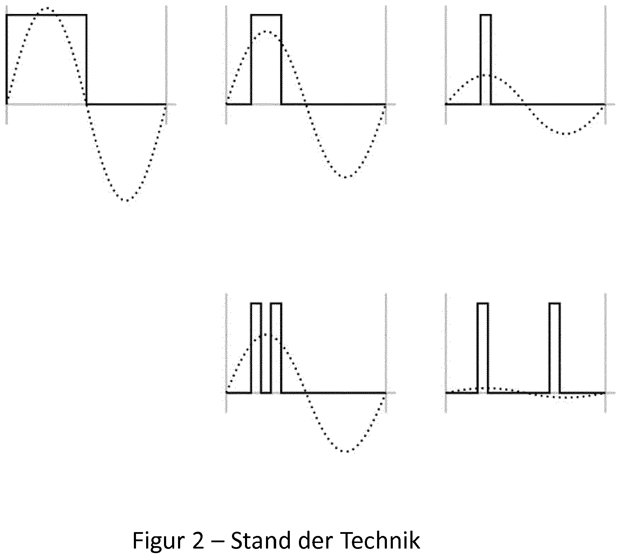

Weitere Modulationsverfahren sind in Stauth, J. et al., "Pulse-density modulation for RF application: The radio-frequency power amplifier (RF PA) as a power Converter", Power Electronics Specialists Conference 2008, S. 3563-3568; F. Raab, "Radio Frequency Pulsewidth Modulation", IEEE Transactions on Communications, S. 958-966, 08/1973; R. Schemel, "Neoteric signal: method for linearising narrow-band amplifiers or signal paths up to their peak powers", Electronic Letters, Vol. 36, Nr. 7, S. 666-667, 30.03.2000 und P. Wagh, "Distortionless RF Pulse Width Modulation", The 2002 45th Midwest Symposium on Circuits and Systems, S. 124-127, 2002 beschrieben. Digitale Verstärker mit Modulatoren sind aus WO 02/073821 A1, EP 2 750 288 A1 und US 2011/267127 A1 US 2015/280732 A1 bekannt. Modulatoren können dann beispielsweise einen Pulsformer umfassen. Die Bitmusterung passt dabei eine Impulsantwort an den Verstärker an und wandelt das Eingangssignal in einen für einen digitalen Verstärker konfigurierten Bitstrom. Pulsformer erzeugen den Bitstrom unter Verwendung eines Amplitudenwertes und einer Phase des Eingangssignals sowie einer Taktfrequenz eines Trägersignals. Die Gesamtbreite aller Pulse in einem Takt des Trägersignals repräsentiert dann zum Beispiel den Amplitudenwert und ein erster Puls repräsentiert die Phase. Manche Pulsformer können einen jeweiligen Amplitudenwert dabei auf unterschiedliche Weise repräsentieren. Beispielsweise kann ein Amplitudenwert von Drei als drei Pulse einer Einheitsbreite, als ein Puls mit entsprechend dreifacher Breite oder zwei Pulse mit einer Gesamtbreite entsprechend drei Einheitsbreiten repräsentiert werden. Dies ist beispielhaft in Figuren 1 und 2 gezeigt. Zusätzlich ist die Pulspause zwischen den Pulsen variierbar. Diese unterschiedlichen Weisen werden auch als Wellenformen oder Bitmuster bezeichnet.

### Offenbarung der Erfindung

Erfindungsgemäß wird ein Modulator nach Anspruch 1 für einen digitalen Verstärker vorgestellt. Der Modulator umfasst einen Pulsformer und eine Steuereinheit zur Steuerung des Pulsformers; der Pulsformer umfasst einen Takteingang und einen Steuereingang, wobei der Pulsformer zur Wandlung eines an einem Eingang der Steuereinheit anliegenden Eingangssignals in einen für den digitalen Verstärker konfigurierten Bitstrom ausgebildet ist, der pro Takt eines am Takteingang anliegenden Taktsignals einen Amplitudenwert des am Eingang der Steuereinheit anliegenden Eingangssignals kodiert. Der Modulator ist dadurch gekennzeichnet, dass der Pulsformer einen jeweiligen Amplitudenwert des Eingangssignals mit unterschiedlichen Bitmustern repräsentieren kann. Das jeweilig durch den Pulsformer verwendete Bitmuster wird durch die Steuereinheit anhand eines entsprechenden, zugehörigen Ansteuerbefehls bestimmt. In der Steuereinheit ist eine Zuordnung der Ansteuerbefehle zu zugehörigen, aus Verstärkung der zugehörigen Bitmuster mit dem digitalen Verstärker resultierenden Amplitudenwerten hinterlegt und es ist vorgesehen, dass die Steuereinheit pro Takt einen Ansteuerbefehl anhand der Zuordnung und des Amplitudenwerts des Eingangssignals auswählt und den Pulsformer entsprechend ansteuert. Der Modulator umfasst weiterhin einen Amplitudenmodulator, wobei der Amplitudenmodulator ausgebildet ist, den Amplitudenwert des Eingangssignals zu kodieren und der Steuereinheit zur Verfügung zu stellen, wobei die Steuereinheit weiterhin ausgebildet ist, das kodierte Signal zur Bestimmung der zu erzeugenden Bitmuster zu verwenden. Der Amplitudenmodulator ist ausgebildet, den Amplitudenwert des Eingangssignals unter Verwendung eines resultierenden Amplitudenwerts zu kodieren, der einem zuvor verwendeten Bitmuster zugeordnet ist.

Der vorgeschlagene Modulator ist bezüglich der in der jeweiligen Implementation erzielbaren Fähigkeiten der Hardware, insbesondere der bitmusternden und/oder der digital verstärkenden Hardware, durch die Zuordenbarkeit von Ansteuerbefehl zu tatsächlich resultierendem Amplitudenwert gemäß dem digitalen Verstärker parametrisierbar. Die nach dem Verstärker tatsächlich resultierende Phasenlange kann ebenfalls erfasst und in der Wellenformtabelle gespeichert werden. So kann dann auch der tatsächliche Phasenfehler des Verstärkers korrigiert werden. Durch geeignete Wahl unter Verwendung der Zuordnung kann der Modulator für den jeweiligen digitalen Verstärker, dessen resultierende Amplitudenwerte den Ansteuerbefehlen zugeordnet sind, optimiert werden, beispielsweise bezüglich Reinheit des Spektrums, Filteranforderungen und/oder Verstärkerwirkungsgrad.

Durch die Zuordenbarkeit kann der Modulator vorteilhaft zur Verbesserung der Wandlung des Eingangssignals in ein digital verstärktes Ausgangssignal verwendet werden.

Die vorliegende Erfindung beschreibt einen neuen Modulator, der die Nachteile der bisher bekannten Verfahren vermindert. Er ist in digitaler Schaltungstechnik beziehungsweise unter Nutzung einfacher signalerzeugender Blöcke implementierbar. Digitale Schaltungen erlauben mehr Bauteiltoleranz und damit verbunden einen kostengünstigeren Fertigungs- und Kalibrierprozess.

In einer bevorzugten Ausführungsform umfasst der Modulator einen Speicher, in dem aus der Verstärkung der unterschiedlichen Bitmuster mit dem Verstärker resultierende Amplitudenwerte den Ansteuerbefehlen zugeordnet sind. Dabei kann die Steuereinheit ausgebildet sein, das zu erzeugende Bitmuster unter Verwendung des Amplitudenwerts des Eingangssignals und der resultierenden Amplitudenwerte zu bestimmen.

Bei geeigneter Wahl der Einträge in der Bitmusterzuordnung besitzt der Modulator eine optimierte Kodiereffizienz.

So lässt sich schnell und einfach die Optimierung des Bitstroms für den Verstärker erreichen.

Die Steuereinheit kann ausgebildet sein, mindestens eine gespeicherte Zuordnung eines resultierenden Amplitudenwerts zu einem der unterschiedlichen Bitmuster mindestens einmal zu ändern.

Damit ist der Modulator konfigurierbar, beziehungsweise adaptierbar, an unterschiedliche Verstärker und/oder Veränderungen der Verstärkerkenngrößen während des Betriebs.

Die Bitmuster können sich durch unterschiedliche Phasen unterscheiden.

Damit lässt sich ein noch besser für den Verstärker geeigneter Bitstrom erzeugen. Durch die Möglichkeit, verschiedene Bitmuster je Takt (Schwingung) des phasenmodulierten Trägersignals zu erzeugen, wird die Detailtreue des resultierenden Ausgangssignals erhöht. Dies schlägt sich in einem reineren Ausgangsspektrum und geringeren Anforderungen an einen Bandpassfilter nieder.

Der Modulator umfasst einen Amplitudenmodulator. Der Amplitudenmodulator ist ausgebildet, den Amplitudenwert des Eingangssignals zu kodieren und der Steuereinheit zur Verfügung zu stellen. Die Steuereinheit ist weiterhin ausgebildet, das kodierte Signal zur Bestimmung des zu erzeugenden Bitmuster zu verwenden.

Der Amplitudenmodulator ist weiterhin ausgebildet, den Amplitudenwert des Eingangssignals unter Verwendung des resultierenden Amplitudenwerts eines zuvor verwendeten Bitmuster zu kodieren.

Dadurch lässt sich Rauschen verringern. Insbesondere verringert die Verwendung des hinterlegten resultierenden Amplitudenwerts anstelle eines tatsächlichen resultierenden Amplitudenwerts eine Feedbackverzögerung und damit ein Aufschwingen des Amplitudenmodulators.

Der Amplitudenmodulator kann ausgebildet sein, den Amplitudenwert unter Verwendung eines mit der Phase modulierten Trägersignals, welches als Taktsignal für den Amplitudenmodulator dient, zu kodieren. Ein Phasenlagenkorrekturwert kann ebenfalls erfasst und in der Wellenformtabelle gespeichert werden. So kann dann auch der tatsächliche Phasenfehler des Verstärkers korrigiert werden.

Der Modulator kann weiterhin eine Eingangsstufe umfassen, die ausgebildet ist, aus einer komplexwertigen Repräsentation des Eingangssignals und einem Trägersignal der Taktfrequenz das phasenmodulierte Trägersignal und ein die Amplitude repräsentierendes Einhüllendensignal zu erzeugen und dem Amplitudenmodulator zur Verfügung zu stellen.

Der Pulsformer kann ausgebildet sein, aus dem phasenmodulierten Trägersignal einen vorläufigen Bitstrom zu erzeugen und diesen unter Verwendung der durch den Amplitudenwert zumindest mitbestimmten Phase zu verzögern, um den Bitstrom zu erzeugen. Die Phase beschreibt, wie weit die Phasenlage des nach dem Verstärker resultierenden Pulses von dem gewünschten Ideal abweicht und ist synonym zu einer zur Kompensation der Abweichung notwendigen Verzögerung. In der Zuordnung können zu einem resultierenden Amplitudenwert zwei unterschiedliche Bitmuster enthalten sein, die sich in der Phase beziehungsweise der Verzögerung unterschieden.

Der Pulsformer kann ausgebildet sein, den vorläufigen Bitstrom durch einen Serialisierungsschaltkreis mit m-facher Überabtastung, wobei m bevorzugt eine natürliche Zahl größer Eins ist, zu erzeugen, m kann jedoch auch gleich Eins sein.

Der Pulsformer kann zusätzlich zur Bitmusterbildung eine Phasenverschiebung vornehmen.

Weiterhin wird erfindungsgemäß eine Vorrichtung gemäß Anspruch 10 zur Wandlung eines Eingangssignals in ein digital verstärktes Signal zur Verfügung gestellt. Die Vorrichtung umfasst einen erfindungsgemäßen Modulator und den digitalen Verstärker.

Die Vorrichtung kann einen dem digitalen Verstärker nachgeordneten Bandpassfilter umfassen, der durch Breitbandfilterung das Ausgangssignal erzeugt. Die Steuereinheit kann dabei ausgebildet sein, den aus der digitalen Verstärkung und der Bandpassfilterung resultierenden Amplitudenwert zur Bestimmung des zu erzeugenden Amplitudenwerts zu verwenden.

Der Amplitudenmodulator kann beispielsweise ein Delta-Sigma-Modulator erster oder höherer Ordnung sein. Ein Delta-Sigma-Modulator kodiert das Einhüllendensignal unter Verwendung des phasenmodulierten Trägersignals mittels einer Negativrückkopplung. Insbesondere kann ein resultierender Amplitudenwert aus der Zuordnung rückgekoppelt werden, der einem zuvor verwendeten Bitmuster zugeordnet ist. Die Kodierung kann dabei auf einer Taktteilung des phasenmodulierten Trägersignals beruhen, die ein kodiertes Signal in je d Takten generiert, wobei d bevorzugt eine natürliche Zahl größer Eins ist, d kann jedoch auch gleich Eins sein. Die rauschformenden Eigenschaften eines Delta-Sigma-Modulators verbessern durch die Rückkopplung die Signalqualität und ermöglichen durch verringerte Anforderungen Einsatz einer größeren Vielfalt von Bandpassfiltern.

Das Basisbandsignal kann wiederum durch eine Eingangsstufe bereitgestellt sein, die ein komplexwertiges Eingangssignal unter Verwendung der Trägerfrequenz in das phasenmodulierte Trägersignal und ein Einhüllendensignal verwandelt.

Die Steuereinheit kann auf einen vorbestimmten Pulsformer und einen vorbestimmten Verstärker festgelegt sein. Die Steuereinheit kann nur auf einen vorbestimmten Pulsformer festgelegt und an ein tatsächliches Verhalten des Verstärkers unter Verwendung des digitalen Ausgangssignals anpassbar sein, initial und/oder zu späteren Zeitpunkten. Das Anpassen der Zuordnung kann unter Verwendung tatsächlich resultierender Amplitudenwerte erfolgen. So kann der tatsächliche Wirkungsgrad und/oder die tatsächliche Linearität der Wandlung initial und/oder später, insbesondere auch wiederkehrend, verbessert, insbesondere optimiert, werden. Die Anpassung kann beispielsweise gedämpft, iterativ und/oder inkrementell erfolgen, um Parametersprünge durch die Anpassung zu vermeiden.

Der Ansteuerbefehl an den Pulsformer kann darauf beruhen, dass die Steuereinheit zum Amplitudenwert einen resultierenden Amplitudenwert in einer in einem Speicher gespeicherten Zuordnung von zumindest aus digitaler Verstärkung resultierenden Amplitudenwerten zu den Ansteuerbefehlen bestimmt und den Pulsformer entsprechend ansteuert. Derjenige resultierende Amplitudenwert mit dem geringsten Abstand zum Amplitudenwert des Eingangssignals kann bestimmt und verwendet werden. Dabei kann der geringste Abstand in der gesamten Zuordnung oder in einer Teilmenge bestimmt werden, die ihrerseits beispielsweise durch zuvor bestimmte Bitmuster bestimmt ist. Die Zuordnung kann insbesondere einem oder mehreren Amplitudenwerten einen Ansteuerbefehl für einen sogenannten Nullpuls zuordnen, wobei der Pulsformer ausgebildet sein kann, keinen Puls zu formen, wenn er mit diesem Ansteuerbefehl angesteuert wird.

Vorteilhafte Weiterbildungen der Erfindung sind in den Unteransprüchen angegeben und in der Beschreibung beschrieben. Zeichnungen

Ausführungsbeispiele der Erfindung werden anhand der Zeichnungen und der nachfolgenden Beschreibung näher erläutert. Es zeigen:
Figur 1 unterschiedliche Bitmuster zur Repräsentation eines beispielhaften Amplitudenwerts innerhalb eines Takts eines Trägersignals,
Figur 2 weitere Beispiele unterschiedlicher Bitmuster zur Repräsentation,
Figur 3 ein erstes Ausführungsbeispiel des erfindungsgemäßen Modulators,
Figur 4 ein zweites Ausführungsbeispiel des erfindungsgemäßen Modulators,
Figur 5 ein drittes Ausführungsbeispiel des erfindungsgemäßen Modulators,
Figur 6 ein viertes Ausführungsbeispiel des erfindungsgemäßen Modulators,
Figur 7 ein Ausführungsbeispiel für einen Pulsformer wie er in Ausführungsbeispielen der Erfindung Verwendung finden kann, und
Figur 8 ein Ausführungsbeispiel der erfindungsgemäßen Vorrichtung.

### Ausführungsformen der Erfindung

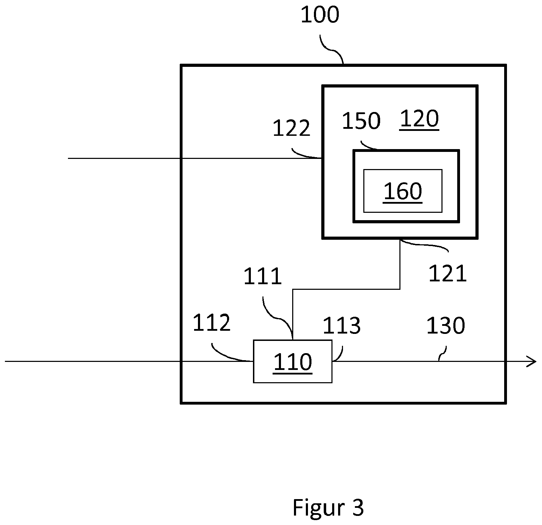

In der Figur 3 ist ein Modulator 100 gemäß einem ersten Ausführungsbeispiel der Erfindung gezeigt. Der Modulator umfasst einen Pulsformer 110 und eine Steuereinheit 120.

Der Pulsformer 110 ist zur Erzeugung eines Bitstroms 130 unter Verwendung einer Amplitude und einer Phase des Eingangssignals sowie einer Taktfrequenz eines Trägersignals ausgebildet. Je Takt des phasenmodulierten Trägersignals erzeugt der Pulsformer eine Repräsentation eines Amplitudenwerts des Eingangssignals. Der Pulsformer 110 kann einen jeweiligen Amplitudenwert dabei auf unterschiedliche Weise repräsentieren. Beispielsweise kann ein Amplitudenwert von Drei als drei Pulse einer Einheitsbreite, ein Puls mit entsprechend dreifacher Breite oder zwei Pulse mit einer Gesamtbreite entsprechend drei Einheitsbreiten repräsentiert werden. Zusätzlich oder alternativ ist die Lückenbreite zwischen den Pulsen variierbar.

Dies ist nur ein beispielhafter Zusammenhang zwischen Pulsen und der resultierenden Amplitude. Figur 2 zeigt weitere Beispiele. Die durchgezogene Linie beschreibt eine jeweils vorgegebene Wellenform, wie sie in der Wellenformtabelle beschrieben wird. Die gestrichelte Linie stellt das resultierende Signal hinter Verstärker und Bandpassfilter dar. In Figur gibt es keine feste Bindung zwischen der zusammengenommenen Breite aller Pulse und der Ausgangsamplitude. Alle Pulse beeinflussen sich gegenseitig in ihrer Wirkung. Dadurch kann beispielsweise durch entsprechende Anordnung zweier Pulsen eine Ausgangsamplitude nahe Null erreicht werden. Dies im letzten Beispiel in Figur 2 gezeigt.

Diese unterschiedlichen Weisen werden auch als Bitmuster bezeichnet. Der Pulsformer 110 umfasst einen Steuereingang 111, über den der Pulsformer zur Verwendung eines der unterschiedlichen Bitmuster anhand entsprechender Ansteuerbefehle angesteuert werden kann. Der Pulsformer 110 umfasst weiterhin einen Takteingang 112 und einen Ausgang 113 für den Bitstrom 130.

Die Steuereinheit 120 umfasst einen Steuerausgang 121, der mit dem Steuereingang 111 des Pulsformers zur Steuerung des Pulsformers 110 elektrisch verbunden ist. Die Steuereinheit 120 umfasst weiterhin einen Eingang 122, über den eine Amplitude des Eingangssignals der Steuereinheit zuführbar ist.

Die Steuereinheit 120 ist zur Steuerung des Pulsformers 110 zur Wandlung eines Eingangssignals in den Bitstrom 130 ausgebildet, wobei die Steuereinheit 120 so ausgebildet ist, dass der erzeugte Bitstrom 130 für einen digitalen Verstärker konfiguriert ist.

Die Steuereinheit 120 ist insbesondere ausgebildet, das zu einem Taktzeitpunkt durch den Pulsformer 110 zu erzeugende Bitmuster zumindest unter Verwendung der Amplitude entsprechend dem vorbestimmten Verstärker zu bestimmen und den Pulsformer 110 entsprechend anzusteuern, so dass ein entsprechend dem bestimmten Bitmuster erzeugter Bitstrompuls für den Verstärker bezüglich zumindest einer der folgenden Verstärkerkenngrößen optimiert ist: Wirkungsgrad, Linearität, Detailtreue und Störabstand.

Im Ausführungsbeispiel der Figur 3 erfolgt dies unter Verwendung eines Speichers 150, in dem in einer Bitmustertabelle 160 aus der Verstärkung der unterschiedlichen Bitmuster mit dem Verstärker resultierende Amplitudenwerte den unterschiedlichen Bitmustern und/oder zugehörigen Ansteuerbefehlen des Pulsformers 110 zugeordnet sind oder eine solche Zuordnung vorgesehen ist. Die Steuereinheit 120 ist im dargestellten Ausführungsbeispiel ausgebildet, je Takt des phasenmodulierten Trägersignals ein Bitmuster unter Verwendung der Bitmustertabelle 160 und des jeweiligen Amplitudenwerts des Eingangssignals für den konkreten Betrieb mit einem digitalen Verstärker zu bestimmen.

Der Modulator ist so für einen jeweilig zusammen mit dem Modulator verwendeten digitalen Verstärker konfigurierbar beziehungsweise vorkonfiguriert. Die Konfigurierung ist jederzeit durch Aktualisierung der in der Bitmustertabelle 160 hinterlegten Amplitudenwerte anhand tatsächlich aus der Verstärkung resultierenden Amplitudenwerten anpassbar.

Die Steuereinheit 120 muss nicht notwendigerweise extern getaktet werden und weist daher nur optional einen Takteingang auf.

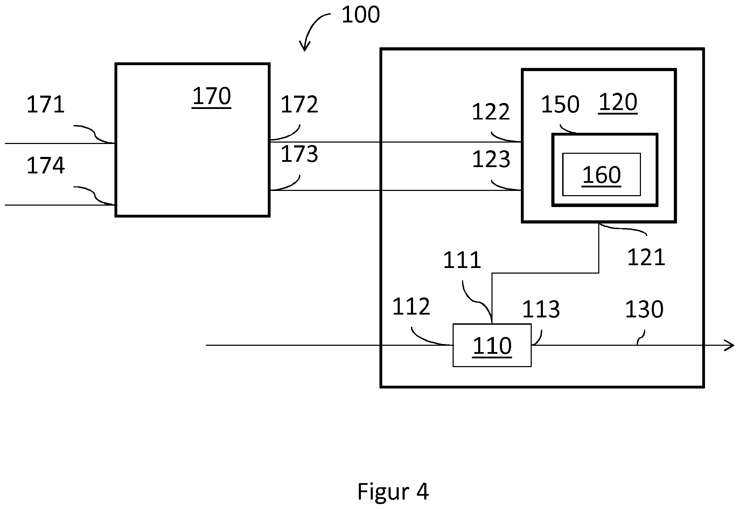

In der Figur 4 ist ein Modulator 100 gemäß einem zweiten Ausführungsbeispiel der Erfindung gezeigt.

Zusätzlich zu der in Figur 3 gezeigten Steuereinheit 120 und dem Pulsformer 110 umfasst der Modulator 100 des zweiten Ausführungsbeispiels einen Amplitudenmodulator 170.

Der Amplitudenmodulator 170 umfasst einen Eingang 171, über den eine Amplitude des Eingangssignals der Steuereinheit zuführbar ist, und einen Ausgang 172, der mit dem Eingang 122 der Steuereinheit 120 elektrisch verbunden ist, und an dem der Amplitudenmodulator 170 die Amplitude des Eingangssignals der Steuereinheit 120 kodiert zur Verfügung stellt, wobei die Steuereinheit 120 des zweiten Ausführungsbeispiels weiterhin ausgebildet ist, das kodierte Signal zur Bestimmung der zu erzeugenden Bitmuster zu verwenden.

Der Amplitudenmodulator 170 umfasst, insbesondere in einer beispielhaften Weiterbildung, einen Rückkopplungseingang 173 und die Steuereinheit 120 einen Amplitudenausgang 123, der mit dem Rückkopplungseingang 173 elektrisch verbunden ist, und an dem die Steuereinheit 120 eine resultierende Amplitude ausgibt. Der Amplitudenmodulator 170 verwendet die zurückgekoppelte resultierende Amplitude für die Kodierung.

Der Amplitudenmodulator ist beispielsweise ein Delta-Sigma-Modulator erster oder höherer Ordnung, so dass die Rückkopplung eine Negativrückkopplung darstellt.

Da die resultierende Amplitude in der Steuereinheit bereits hinterlegt ist, kann diese frühzeitig rückgekoppelt werden. Dadurch wird ein Aufschwingen, wie es bei Verwendung des zurückgemessenen tatsächlichen Verstärkerausgangs auftritt, des Amplitudenmodulators 170 zuverlässig verhindert.

Der Amplitudenmodulator 170 umfasst insbesondere in einer anderen beispielhaften Weiterbildung einen Takteingang 174, an den eine Taktfrequenz des Trägersignals anlegbar ist. Der Amplitudenmodulator 170 ist in dieser Weiterbildung weiterhin ausgebildet, die Amplitude unter Verwendung der Taktfrequenz zu kodieren.

Im Ausführungsbeispiel aus Figur 4 umfasst der Block 120 keinen Takteingang. In einem anderen Ausführungsbeispiel umfasst der Block 120 jedoch einen Takteingang, der beispielsweise mit einem Takt ,der aus dem Amplitudenmodulator 170 kommt, beaufschlagt ist.

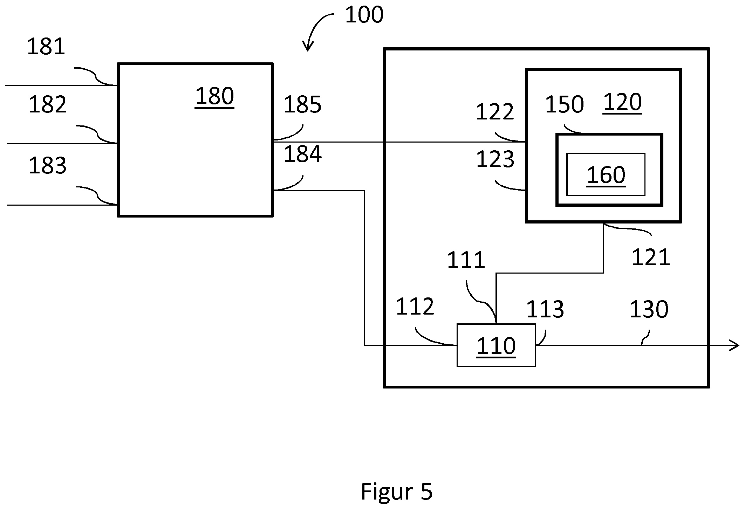

In der Figur 5 ist ein Modulator 100 gemäß einem dritten Ausführungsbeispiel der Erfindung gezeigt.

Zusätzlich zu der in Figur 3 gezeigten Steuereinheit 120 und dem Pulsformer 110 umfasst der Modulator 100 des dritten Ausführungsbeispiels eine Eingangsstufe 180.

Die Eingangsstufe 180 umfasst drei Eingänge 181, 182, 183 und zwei Ausgänge 184, 185. An zwei der Eingänge 181, 182 können I- und Q-Komponenten einer komplexwertigen Repräsentation des Eingangssignals angelegt werden. An den dritten Eingang 183 ist das Trägersignal mit der Taktfrequenz anlegbar. Liegen I- und Q-Komponenten und Trägersignal an, so ist am Ausgang 184 das mit der Phase des Eingangssignals verschobene Trägersignal und am Ausgang 185 ein Einhüllendensignal abnehmbar, welches die Amplitude des Eingangssignals repräsentiert.

Ausgang 185 ist im dritten Ausführungsbeispiel mit dem Eingang 122 elektrisch verbunden und Ausgang 184 ist mit dem Takteingang 112 elektrisch verbunden.

Der erfindungsgemäße Modulator 100 nimmt im dritten Ausführungsbeispiel das zu verstärkende Signal als komplexwertiges Eingangssignal in Inphase/Quadraturkomponentendarstellung (I und Q) sowie eine Repräsentation des gewünschten Trägersignals, beispielsweise eine Sinusschwingung mit einer Taktfrequenz, entgegen. In der Eingangsstufe 180 wird aus diesen Daten die Amplitudeninformation der Einhüllenden ermittelt. Zusätzlich wird die Phaseninformation des Eingangssignals benutzt, um das Trägersignal in der Phase zu modulieren.

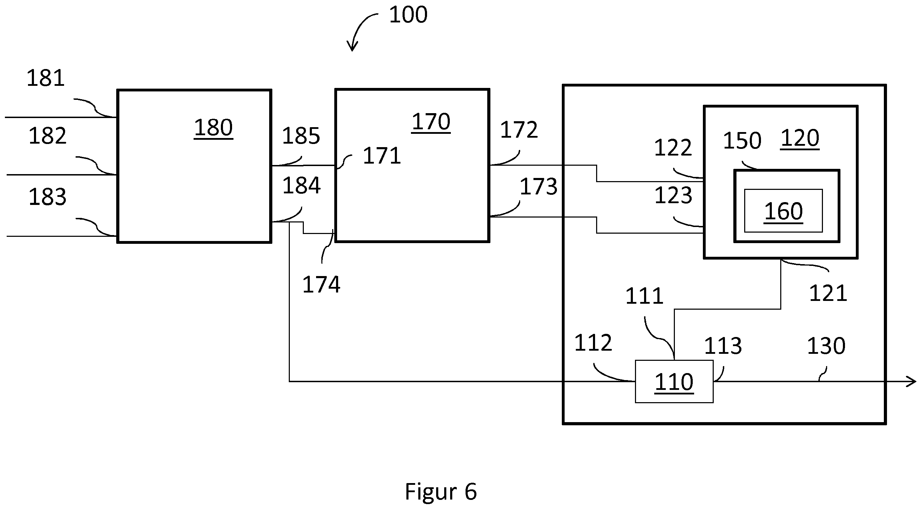

In der Figur 6 ist ein Modulator 100 gemäß einem vierten Ausführungsbeispiel der Erfindung gezeigt.

Zusätzlich zu der in Figur 3 gezeigten Steuereinheit 120 und dem Pulsformer 110 umfasst der Modulator 100 des vierten Ausführungsbeispiels den Amplitudenmodulator 170 und die Eingangsstufe 180.

Ausgang 185 ist im vierten Ausführungsbeispiel mit dem Eingang 171 elektrisch verbunden und Ausgang 184 ist mit dem Takteingang 112 und mit dem Takteingang 174 elektrisch verbunden. Die elektrischen Verbindungen zwischen Amplitudenmodulator 170 und Steuereinheit 120 entsprechen denen des zweiten Ausführungsbeispiels.

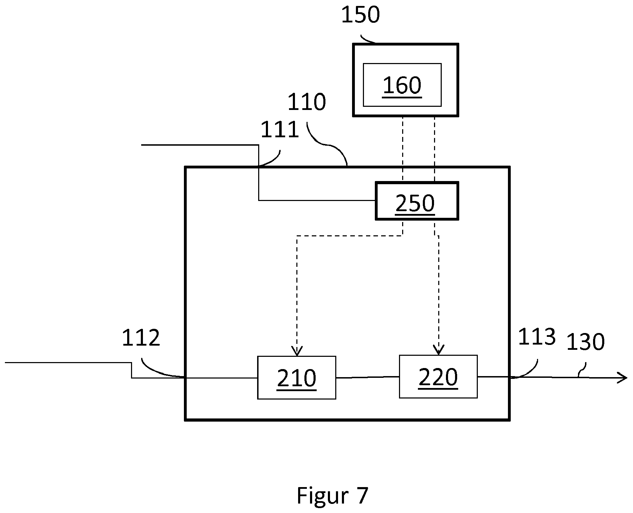

Figur 7 zeigt ein Ausführungsbeispiel für einen Pulsformer 110, wie er in Ausführungsbeispielen der Erfindung Verwendung finden kann.

Der Pulsformer 110 umfasst einen m-fach Überabtaster (Frequenzmultiplizierter) der das am Takteingang 112 anliegende Signal m-fach überabtastet und so auf m-fache Frequenz anhebt, wobei m bevorzugt eine Zahl größer Eins ist, jedoch auch gleich Eins sein kann, und einen Bitstrom-Serialisierer 210, der das Signal am Eingang 112 um den Faktor m in seiner Frequenz erhöht. Unter Zuhilfenahme dieses neuen, schnelleren, Taktes wandelt der Bitstrom-Serialisierer 210 die ausgewählte Wellenformrepräsentation aus der Tabelle in einen Bitstrom. Das Bitmuster, mit der Bits des Bitstroms durch den Bitstrom-Serialisierer 210 erzeugt werden, ist durch den jeweiligen Ansteuerbefehl am Steuereingang 111 bestimmt. Der Pulsformer 110 umfasst im dargestellten Beispiel weiterhin eine steuerbare Verzögerungsleitung 220, über die der Bitstrom verzögert werden kann.

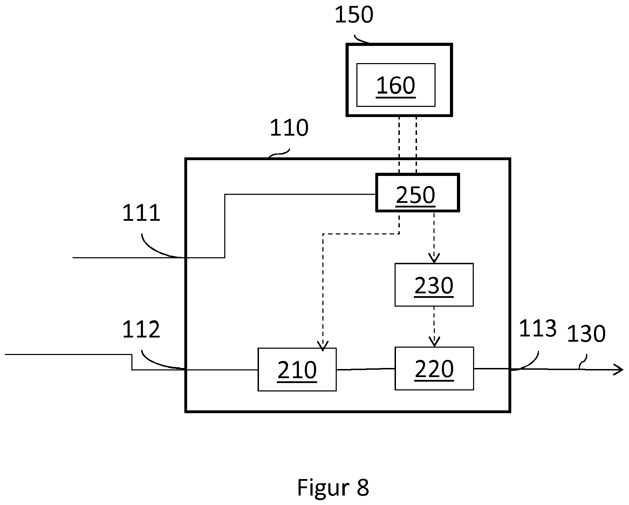

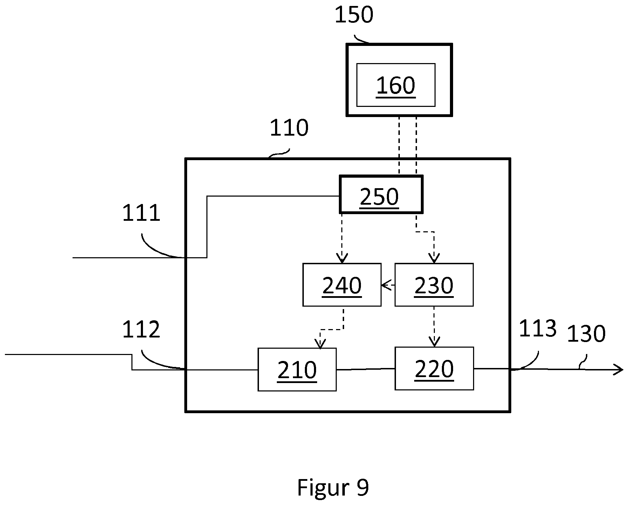

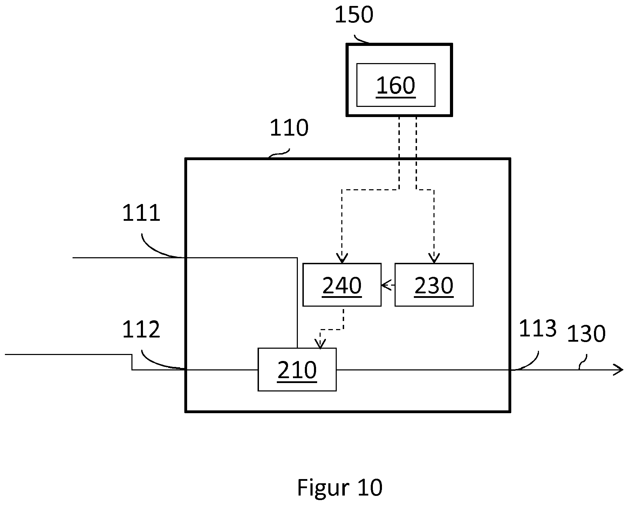

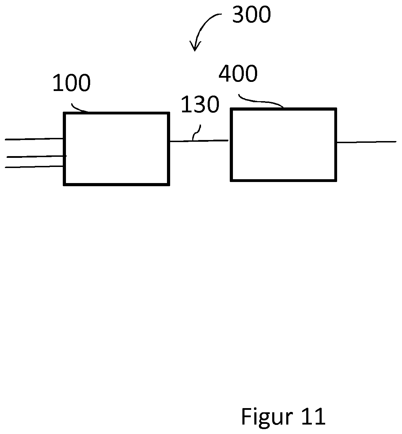

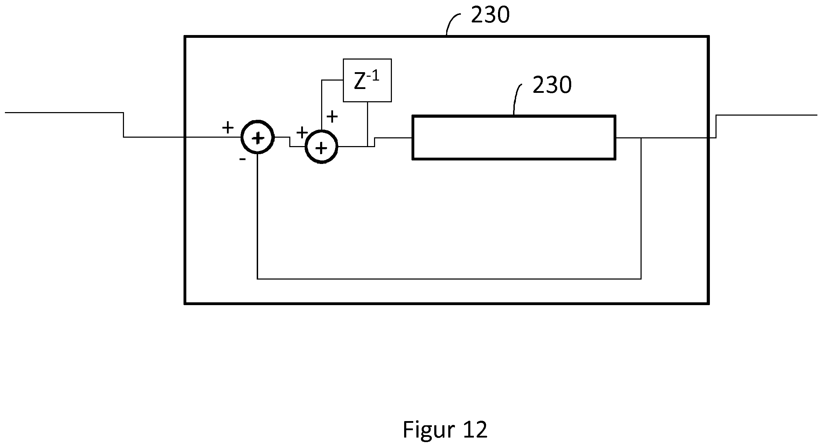

Figur 8 zeigt ein Ausführungsbeispiel für eine Vorrichtung 300 gemäß einem Ausführungsbeispiel der Erfindung.

Die Vorrichtung 300 umfasst den erfindungsgemäßen Modulator 100 und einen digitalen Verstärker 400. Der Modulator 100 erzeugt dabei aus Amplitude und Phase eines Eingangssignals einen Bitstrom 130. Der Bitstrom 130 wird vom Verstärker 400 anschließend digital verstärkt. In der Steuereinheit des Modulators 100 sind in der Bitmustertabelle die aus den jeweiligen Bitmustern resultierenden Amplituden des digitalen Verstärkers 400 den Ansteuerbefehlen zugeordnet hinterlegt.

Im Ausführungsbeispiel der Figur 8 kann der Modulator 100 insbesondere gemäß einem der Ausführungsbeispiele aus den Figuren 1 - 4 ausgebildet sein.

Der erfindungsgemäße Modulator kann sehr flexibel auf die jeweiligen Eigenschaften und Möglichkeiten des Verstärkers, des Pulsformers und/oder der weiteren Komponenten angepasst werden.

Für die Steuereinheit sind verschiedene Realisierungsvarianten denkbar:
In der einfachsten Variante wählt die Steuereinheit denjenigen Eintrag der Bitmustertabelle aus, dessen Amplitudenwert dem Eingangswert der Steuereinheit mit der geringsten Abweichung entspricht. In einer erweiterten Variante wäre es denkbar, dass die Steuereinheit nach festgelegten Regeln von dieser Methode abweicht, um ein vorteilhafteres Verhalten der Gesamtschaltung aus Modulator und Verstärker zu erreichen. So können beispielsweise Pulse ausgelassen werden (es wird ein Bitmustertabelleneintrag ausgewählt, der den Pulsformer anweist, keine Pulse auszugeben), um die Zustandswechsel im Verstärker zu minimieren und so die durch Umladungsverluste erzeugten Energieverluste zu verringern. Viele weitere Algorithmen, die bestimmte Parameter optimieren, sind denkbar.

Der Amplitudenmodulator kann als Delta-Sigma-Modulator erster Ordnung ausgelegt sein. Ein solcher Delta-Sigma-Modulator kann die Information der Steuereinheit, welches Bitmuster tatsächlich ausgewählt wurde, benutzen, um den Diskretisierungsfehler zu ermitteln und entsprechend reagieren. Die rauschformenden Eigenschaften des Delta-Sigma-Modulators können hier nutzbringend angewandt werden, um die Anforderungen an den Ausgangsfilter des Verstärkers zu verringern und die Signalqualität zu verbessern. In einer anderen Variation kann auch ein Delta-Sigma-Modulator höherer Ordnung oder ein gänzlich anderes Modulatorkonzept genutzt werden. Es ist ebenfalls denkbar, den Amplitudenmodulator ganz zu entfernen und der Steuereinheit direkt das Einhüllendensignal der Eingangsstufe zuzuführen.
Der Amplitudenmodulator und die Steuereinheit erzeugen für jede vollständige Schwingung des phasenmodulierten Trägersignals je eine Erzeugungsanweisung für den Pulsformer. Mit dem Taktteilerblock am Takteingang der Modulationsstufe kann jedoch auch erreicht werden, dass nur alle d Schwingungen des Trägersignals eine Anweisung erzeugt wird. Die Einträge der Bitmustertabelle enthalten dann Bitmuster, die jeweils d Takte lang sind. Dabei ist d bevorzugt eine natürliche Zahl größer Eins, d kann jedoch auch gleich Eins sein.

Der Modulator ist nicht auf digitale Verstärker mit nur einem (binären) Eingang beschränkt, es können ohne weiteres auch Verstärker mit mehreren Eingängen betrieben werden. Es ist lediglich die bitmusterbildende Einheit entsprechend zu erweitern bzw. zu vervielfältigen und die zusätzlichen Informationen in der Bitmustertabelle zu speichern.

Der Modulator erlaubt es zudem, auf einfache Weise eine Korrektur der Parameter vorzunehmen, um die Linearität des Verbundes aus Modulator und Verstärker zu erhöhen. Hierzu können aus dem Ausgangssignal des Verstärkers (vor oder nach dem Bandpassfilter) für jedes in der Bitmustertabelle gespeicherte Bitmuster die tatsächlich resultierende Amplitude sowie die tatsächliche Phasenlage ermittelt werden. Diese Werte können anschließend in die Bitmustertabelle übernommen werden. Durch die nun besser zu den tatsächlichen Hardwareeigenschaften passenden Parameter wird eine Verbesserung des Ausgangssignals hinsichtlich seiner Linearität erreicht.

In einer weiteren Variante ist es möglich, die beschriebene Korrektur der Bitmustertabelleneinträge nicht nur einmalig sondern wiederholt durchzuführen. Da die Ermittlung der beschriebenen Werte auch anhand des eigentlichen Nutzsignals erfolgen kann, ist es möglich, diese Korrektur auch während des Betriebs durchzuführen. Das Ausgangssignal kann hierzu in Ausschnitten oder sogar durchgängig für diese Aufgabe herangezogen werden. Um abrupte Sprünge der Parameter beim Aktualisieren der Bitmustertabelle zu vermeiden, kann es sinnvoll sein, die bisherigen Werte zu berücksichtigen und eine gedämpfte bzw. inkrementelle und/oder iterative Anpassung durchzuführen.

Ein Ausführungsbeispiel der Erfindung umfasst ein Verfahren, mit dem ein Eingangssignal in eine Folge digitaler Pulse verwandelt werden kann, die geeignet sind, von einem digitalen Leistungsverstärker so verstärkt zu werden, dass aus den verstärkten Pulsen durch eine Bandpassfilterung das verstärkte Eingangssignal gewonnen werden kann.

In dem Ausführungsbeispiel existiert eine Bitmustertabelle, in der geeignete Bitmuster zusammen mit ihren beiden wesentlichen Kriterien - resultierende Amplitude und resultierende Phasenlage des Sendesignals - gespeichert sind, die beliebig gewählt werden können.

Für jede Periode des phasenmodulierten Signals wird das kodierte Signal der Einhüllenden der Steuereinheit zugeführt, die daraus anhand bestimmter Regeln einen Eintrag aus der Bitmustertabelle auswählt und entsprechende, in der Tabelle definierte Bitmuster im Bitstrom umsetzt.

Das Eingangssignal kann komplexwertig sein und/oder in Inphase/Quadraturkomponentendarstellung vorliegen.

Ein rauschformendes Modulationsverfahren, beispielsweise Delta-Sigma-Modulation, kann zur Amplitudenmodulation verwendet werden.

Die Einträge in der Bitmustertabelle können während des Betriebs geändert werden.

Beispielsweise werden Einträge in der Bitmustertabelle während des Betriebs automatisch so angepasst, dass die nichtlinearen Verzerrungen oder andere Eigenschaften des modulierten Signals optimiert werden.

In einem weiteren Ausführungsbeispiel nimmt der Pulsformer zusätzlich eine Phasenverschiebung vor.

In einem anderen Ausführungsbeispiel umfasst die Vorrichtung einen dem digitalen Verstärker nachgeordneten Bandpassfilter, der durch Breitbandfilterung das Ausgangssignal erzeugt. Die Steuereinheit ist dabei in einer beispielhaften Weiterbildung dieses Ausführungsbeispiels ausgebildet, die aus der digitalen Verstärkung und der Bandpassfilterung oder die lediglich aus der digitalen Verstärkung resultierende Amplitude zur Bestimmung der zu erzeugenden Amplitude zu verwenden. Zusätzlich kann die resultierende Phase Berücksichtigung finden.

Der Amplitudenmodulator ist beispielsweise ein Delta-Sigma-Modulator erster oder höherer Ordnung, der das Einhüllendensignal unter Verwendung des phasenmodulierten Trägersignals mittels einer Negativrückkopplung eines einem zuvor zur Verwendung bestimmten Bitmuster zugeordneten, resultierenden Amplitudenwerts kodiert. Die Kodierung kann dabei auf einer Taktteilung des phasenmodulierten Trägersignals beruhen, die ein kodiertes Signal in je d Takten des Ansteuersignals generiert, d ist eine natürliche Zahl größer oder gleich Eins. Die rauschformenden Eigenschaften eines Delta-Sigma-Modulators verbessern durch die Rückkopplung die Signalqualität und ermöglichen durch verringerte Anforderungen Einsatz einer größeren Vielfalt von Bandpassfiltern.

Das phasenmodulierte Trägersignal ist wiederum beispielsweise durch eine Inphase/Quadraturkomponentendarstellung bereitgestellt, die ein komplexwertiges Eingangssignal unter Verwendung der Trägerfrequenz in das phasenmodulierte Trägersignal und ein Einhüllendensignal verwandelt.

Die Steuereinheit ist in einem ersten Ausführungsbeispiel auf einen vorbestimmten Pulsformer und einen vorbestimmten Verstärker festgelegt. Die Steuereinheit ist in einem zweiten Ausführungsbeispiel nur auf einen vorbestimmten Pulsformer an ein tatsächliches Verhalten des Verstärkers unter Verwendung des digitalen Ausgangssignals anpassbar, initial und/oder zu späteren Zeitpunkten. Beispielsweise durch Anpassen der Zuordnung unter Verwendung tatsächlich resultierender Amplituden. So kann der tatsächliche Wirkungsgrad und/oder die tatsächliche Linearität der Wandlung initial und/oder später, insbesondere auch wiederkehrend, verbessert, insbesondere optimiert, werden. Die Anpassung kann beispielsweise gedämpft, iterativ und/oder inkrementell erfolgen, um Parametersprünge durch die Anpassung zu vermeiden.
Die Steuereinheit ist ausgebildet, zu einem Amplitudenwert des Eingangssignals ein Bitmuster zu bestimmen und einen Pulsformer entsprechend anzusteuern, so dass dieser das bestimmte Bitmuster verwendet. Dies kann beispielsweise darauf beruhen, dass die Steuereinheit zu dem Amplitudenwert einen resultierenden Amplitudenwert in einer in einem Speicher gespeicherten Zuordnung von zumindest aus digitaler Verstärkung resultierenden Amplituden zu durch den Pulsformer verwendbaren Bitmustern bestimmt und den Pulsformer zur Verwendung des zugeordneten Bitmusters ansteuert. Beispielsweise kann der resultierende Amplitudenwert mit dem geringsten Abstand bestimmt und verwendet werden, gegebenenfalls zusammen mit einer weiterhin zugeordneten Phasenlage. Dabei kann der geringste Abstand in der gesamten Zuordnung oder in einer Teilmenge bestimmt werden, die ihrerseits beispielsweise durch zuvor bestimmte Bitmuster bestimmt ist. Die Zuordnung kann insbesondere einem oder mehreren resultierenden Amplitudenwerten einen Ansteuerbefehl für einen sogenannten Nullpuls zuordnen, wobei der Pulsformer ausgebildet sein kann, keinen Puls zu formen, wenn er mit diesem Ansteuerbefehl angesteuert wird.

Für digitale Implementierungen existieren rekonfigurierbare Bausteine, beispielsweise programmierbare Gatter-Anordnungen (FPGA) oder anwendungsspezifische Prozessoren wie anwendungsspezifische integrierte Schaltkreise (ASICs), die eine schnelle Anpassung eines, einiger und/oder aller Parameter im Feld oder sogar im laufenden Betrieb ermöglichen. Kosten für kundenspezifische Anpassungen können so minimiert werden. Neue Anwendungen, die eine dynamische Anpassung der Parameter benötigen, werden ermöglicht.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung gemäss der Ansprüche zu verlassen.

## Patentansprüche

1. Modulator (100) für einen digitalen Verstärker (400), wobei der Modulator (100) umfasst: einen Pulsformer (110) und eine Steuereinheit (120) zur Steuerung des Pulsformers (110); der Pulsformer (110) umfassend einen Takteingang (112) und einen Steuereingang (111), wobei der Pulsformer (110) zur Wandlung eines an einem Eingang (122) der Steuereinheit (120) anliegenden Eingangssignals in einen für einen digitalen Verstärker (400) konfigurierten Bitstrom (130) ausgebildet ist, der pro Takt eines am Takteingang (112) anliegenden Taktsignals einen Amplitudenwert des am Eingang (122) der Steuereinheit (120) anliegenden Eingangssignals kodiert,
wobei der Pulsformer (110) einen jeweiligen Amplitudenwert des Eingangssignals mit unterschiedlichen Bitmustern repräsentieren kann und das jeweilig durch den Pulsformer (110) verwendete Bitmuster durch die Steuereinheit (120) anhand eines an den Steuereingang (111) des Pulsformer (110) angelegten entsprechenden, zugehörigen Ansteuerbefehls bestimmt wird, wobei in der Steuereinheit (120) eine Zuordnung (160) der Ansteuerbefehle zu zugehörigen, aus Verstärkung der zugehörigen Bitmuster mit dem digitalen Verstärker (400) resultierenden Amplitudenwerten hinterlegt ist und vorgesehen ist, wobei die Steuereinheit (120) pro Takt einen Ansteuerbefehl anhand der Zuordnung (160) und des jeweiligen Amplitudenwerts des Eingangssignals auswählt und den Pulsformer (110) entsprechend ansteuert, wobei der Modulator (100) weiterhin einen Amplitudenmodulator (170) umfasst, wobei der Amplitudenmodulator (170) ausgebildet ist, den Amplitudenwert des Eingangssignals zu kodieren und der Steuereinheit (120) zur Verfügung zu stellen, wobei die Steuereinheit (120) weiterhin ausgebildet ist, das kodierte Signal zur Bestimmung der zu erzeugenden Bitmuster zu verwenden, wobei der Amplitudenmodulator (170) ausgebildet ist, den Amplitudenwert des Eingangssignals unter Verwendung des resultierenden Amplitudenwerts zu kodieren, der einem zuvor verwendeten Bitmuster zugeordnet ist.

2. Modulator nach Anspruch 1, weiterhin umfassend einen Speicher (150), in dem die Zuordnung (160) der Ansteuerbefehle zu den resultierenden Amplitudenwerten gespeichert ist.

3. Modulator nach Anspruch 2, wobei die Steuereinheit (120) ausgebildet ist, mindestens einen zugeordneten, resultierenden Amplitudenwert mindestens einmal zu ändern.

4. Modulator nach Anspruch 2 oder 3, wobei sich zumindest einige der Bitmuster in der Zuordnung durch unterschiedliche Phasen unterscheiden.

5. Modulator nach einem der vorangehenden Ansprüche, wobei die Steuereinheit (120) ausgebildet ist, das zu erzeugende Bitmuster so zu bestimmen, dass ein Parameter, der von einer Reinheit des Spektrums, Filteranforderungen und/oder einem Verstärkerwirkungsgrad abhängt, optimiert ist.

6. Modulator nach einem der vorhergehenden Ansprüche, wobei der Amplitudenmodulator (170) ausgebildet ist, den Amplitudenwert unter Verwendung des mit der Phase modulierten Trägersignals zu kodieren.

7. Modulator nach Anspruch 6, weiterhin umfassend eine Eingangsstufe (180), die ausgebildet ist, aus einer komplexwertigen Repräsentation des Eingangssignals und einem Trägersignal der Taktfrequenz das phasenmodulierte Trägersignal und ein den Amplitudenwert repräsentierendes Einhüllendensignal zu erzeugen und dem Amplitudenmodulator (170) zur Verfügung zu stellen.

8. Modulator nach einem der vorangehenden Ansprüche, wobei der Pulsformer (110) weiterhin einen m-fach Überabtaster und einen Bitstrom-Serialisierer (210) umfasst, wobei der m-fach Überabtaster ausgebildet ist, das am Takteingang (112) anliegende Taktsignal m-fach überabzutasten und so auf m-fache Frequenz anzuheben, wobei m eine Zahl größer Eins ist, und wobei der Bitstrom-Serialisierer (210) ausgebildet ist, das Eingangssignal unter Zuhilfenahme des erhöhten Taktes in einen durch den ausgewählten Ansteuerbefehl bestimmten Bitstrom zu wandeln.

9. Modulator nach einem der vorangehenden Ansprüche, wobei die Steuereinheit (120) pro Takt einen Ansteuerbefehl anhand der Zuordnung (160) und des jeweiligen Amplitudenwerts des Eingangssignals auswählt und den Pulsformer (110) entsprechend ansteuert, so dass ein entsprechend dem bestimmten Bitmuster erzeugter Bitstrompuls für den digitalen Verstärker bezüglich zumindest einer der folgenden Verstärkerkenngrößen optimierend angepasst ist: Wirkungsgrad, Linearität, Detailtreue und Störabstand.

10. Vorrichtung zur Wandlung eines Eingangssignals in ein digital verstärktes Signal, wobei die Vorrichtung (300) einen Modulator (100) nach einem der vorangehenden Ansprüche und den digitalen Verstärker (400) umfasst.

## Claims

1. A modulator (100) for a digital amplifier (400), wherein the modulator (100) comprises: a pulse shaper (110) and a control unit (120) for controlling the pulse shaper (110); the pulse shaper (110) comprising a clock input (112) and a control input (111), wherein the pulse shaper (110) is adapted to convert an input signal applied to an input (122) of the control unit (120) into a bit stream (130) configured for a digital amplifier (400), which encodes per clock of a clock signal applied to the clock input (112) an amplitude value of the input signal applied to the input (122) of the control unit (120), wherein the pulse shaper (110) can represent a respective amplitude value of the input signal with different bit patterns and the respective bit pattern used by the pulse shaper (110) is determined by the control unit (120) by means of a corresponding, associated control command applied to the control input (122) of the pulse shaper (110), wherein an assignment (160) of the control commands to associated amplitude values resulting from amplification of the associated bit patterns with the digital amplifier (400) is stored and provided in the control unit (120), wherein the control unit (120) selects a control command per clock by means of the assignment (160) and the respective amplitude value of the input signal and controls the pulse shaper (110) accordingly, wherein the modulator (100) further comprises an amplitude modulator (170), wherein the amplitude modulator (170) is adapted to encode the amplitude value of the input signal and to provide it to the control unit (120), wherein the control unit (120) is further adapted to use the encoded signal to determine the bit patterns to be generated, wherein the amplitude modulator (170) is adapted to encode the amplitude value of the input signal using the resulting amplitude value which is associated with a previously used bit pattern.

2. The modulator according to Claim 1, further comprising a memory (150) in which the assignment (160) of the control commands to the resulting amplitude values is stored.

3. The modulator according to Claim 2, wherein the control unit (120) is adapted to change at least one associated resulting amplitude value at least once.

4. The modulator according to Claim 2 or 3, wherein at least some of the bit patterns differ in assignment by different phases.

5. The modulator according to any one of the preceding claims, wherein the control unit (120) is adapted to determine the bit pattern to be generated such that a parameter which depends on a purity of the spectrum, filter requirements and/or an amplifier efficiency is optimized.

6. The modulator according to any one of the preceding claims, wherein the amplitude modulator (170) is adapted to encode the amplitude value using the carrier signal modulated with the phase.

7. The modulator according to Claim 6, further comprising an input stage (180) which is adapted to generate the phase-modulated carrier signal and an envelope signal representing the amplitude value from a complex-valued representation of the input signal and a carrier signal of the clock frequency, and to provide it to the amplitude modulator (170).

8. The modulator according to any one of the preceding claims, wherein the pulse shaper (110) further comprises an m-times oversampler and a bit stream serializer (210), wherein the m-times oversampler is adapted to oversample the clock signal applied to the clock input (112) m times and thus raise it to m-times frequency, wherein m is a number greater than one, and wherein the bit stream serializer (210) is adapted to convert the input signal into a bit stream determined by the selected control command with the aid of the increased clock.

9. The modulator according to any one of the preceding claims, wherein the control unit (120) selects a control command per clock by means of the assignment (160) and the respective amplitude value of the input signal and controls the pulse shaper (110) accordingly, such that a bit stream pulse generated according to the determined bit pattern is optimized for the digital amplifier with respect to at least one of the following amplifier characteristics:
efficiency, linearity, detail fidelity and signal-to-noise ratio.

10. A device for converting an input signal into a digitally amplified signal, wherein the device (300) comprises a modulator (100) according to any one of the preceding claims and the digital amplifier (400).

## Revendications

1. Modulateur (100) pour un amplificateur numérique (400), le modulateur (100) comprenant: un formateur d'impulsions (110) et une unité de commande (120) pour la commande du formateur d'impulsions (110); le formateur d'impulsions (110) comprenant une entrée d'impulsion (112) et une entrée de commande (111), le formateur d'impulsions (110) étant formé pour la conversion d'un signal d'entrée appliqué à une entrée (122) de l'unité de commande (120) en un train de bits (130) configuré pour un amplificateur numérique (400), lequel code une valeur d'amplitude du signal d'entrée appliqué à l'entrée (122) de l'unité de commande (120) par impulsion d'un signal d'impulsion appliqué à l'entrée d'impulsion (112),
le formateur d'impulsions (110) pouvant représenter une valeur d'amplitude respective du signal d'entrée avec des motifs de bits différents et le motif de bits utilisé respectivement par le formateur d'impulsions (110) étant déterminé par l'unité de commande (120) à l'aide d'une commande d'excitation associée correspondante appliquée à l'entrée de commande (111) du formateur d'impulsions (110), une attribution (160) des commandes d'excitation à des valeurs d'amplitude associées résultant de l'amplification des motifs de bits associés par l'amplificateur numérique (400) étant enregistrée et étant prévue dans l'unité de commande (120),
l'unité de commande (120) sélectionnant une commande d'excitation à l'aide de l'association (160) et de la valeur d'amplitude respective du signal d'entrée, par impulsion, et excitant le formateur d'impulsions (110) corrélativement, le modulateur (100) comprenant en outre un modulateur d'amplitude (170), le modulateur d'amplitude (170) étant formé afin de coder la valeur d'amplitude du signal d'entrée et de la mettre à disposition de l'unité de commande (120), l'unité de commande (120) étant en outre formée afin d'utiliser le signal codé pour la détermination du motif de bits devant être généré, le modulateur d'amplitude (170) étant formé afin de coder la valeur d'amplitude du signal d'entrée en utilisant la valeur d'amplitude résultante, laquelle est associée à un motif de bits utilisé précédemment.

2. Modulateur selon la revendication 1, comprenant en outre une mémoire (150), dans laquelle l'attribution (160) des commandes d'excitation aux valeurs d'amplitude résultantes est enregistrée.

3. Modulateur selon la revendication 2, l'unité de commande (120) étant formée afin de modifier au moins une valeur d'amplitude attribuée résultante au moins une fois.

4. Modulateur selon la revendication 2 ou 3, au moins quelques-uns des motifs de bits étant distincts les uns des autres du fait de phases différentes, relativement à l'attribution.

5. Modulateur selon l'une des revendications précédentes, l'unité de commande (120) étant formée afin de déterminer le motif de bits devant être généré de telle sorte qu'un paramètre dépendant d'une pureté du spectre, d'exigences de filtrage et/ou d'un rendement de l'amplificateur est optimisé.

6. Modulateur selon l'une des revendications précédentes, le modulateur d'amplitude (170) étant formé afin de coder la valeur d'amplitude en utilisant le signal porteur modulé en phase.

7. Modulateur selon la revendication 6, comprenant en outre un étage d'entrée (180), lequel est formé afin de générer le signal porteur modulé en phase et un signal d'enveloppe représentant la valeur d'amplitude à partir d'une représentation de valeur complexe du signal d'entrée et d'un signal porteur de la fréquence d'impulsion, et de les mettre à disposition du modulateur d'amplitude (170).

8. Modulateur selon l'une des revendications précédentes, le formateur d'impulsions (110) comprenant en outre un suréchantillonneur m-uple et un sérialiseur de train de bits (210), le suréchantillonneur m-uple étant formé afin de suréchantillonner m fois le signal d'impulsion appliqué à l'entrée d'impulsion (112) et d'élever ainsi m fois la fréquence, m étant un nombre supérieur à 1, et le sérialiseur de train de bits (210) étant formé afin de convertir le signal d'entrée en un train de bits déterminé par la commande d'excitation sélectionnée, en ayant recours à l'impulsion augmentée.

9. Modulateur selon l'une des revendications précédentes, l'unité de commande (120) sélectionnant une commande d'excitation par impulsion à l'aide de l'attribution (160) et de la valeur d'amplitude respective du signal d'entrée, et excitant corrélativement le formateur d'impulsions (110) de telle sorte qu'une pulsation de train de bits générée de façon corrélative au motif de bits déterminé est ajustée en vue de l'optimisation pour l'amplificateur numérique, relativement à au moins une des caractéristiques d'amplification suivantes :
rendement, linéarité, finesse des détails et rapport signal/bruit.

10. Dispositif pour la conversion d'un signal d'entrée en un signal numérique amplifié, le dispositif (300) comprenant un modulateur (100) selon l'une des revendications précédentes et l'amplificateur numérique (400).
